(19) **Europäisches Patentamt**
**European Patent Office**
**Office européen des brevets**

(11) **EP 1 385 193 B1**

(12) **EUROPÄISCHE PATENTSCHRIFT**

(45) Veröffentlichungstag und Bekanntmachung des Hinweises auf die Patenterteilung:
**02.05.2012 Patentblatt 2012/18**

(51) Int Cl.:
**H01J 37/145** (2006.01)   **H01J 37/30** (2006.01)

(21) Anmeldenummer: **03016238.2**

(22) Anmeldetag: **17.07.2003**

(54) **Objektivlinse für ein Elektronenmikroskopiesystem und Elektronenmikroskopiesystem**

Objective lens for an electron microscopy system, and electron microscopy system

Lentille d'objectif pour système de microscopie électronique, et système de microscopie électronique

(84) Benannte Vertragsstaaten:
**CZ DE GB NL**

(30) Priorität: **19.07.2002 DE 10233002**

(43) Veröffentlichungstag der Anmeldung:
**28.01.2004 Patentblatt 2004/05**

(60) Teilanmeldung:
**11008617.0 / 2 418 673**

(73) Patentinhaber: **Carl Zeiss NTS GmbH**
**73447 Oberkochen (DE)**

(72) Erfinder:
- **Preikszas, Dirk, Dr.**
  **73447 Oberkochen (DE)**
- **Steigerwald, Michael, Dr.**
  **73434 Aalen (DE)**
- **Hoffrogge, Peter, Dipl.-Phys.**
  **73447 Oberkochen (DE)**
- **Gnauck, Peter, Dr.**
  **72764 Reutlingen (DE)**

(74) Vertreter: **Schorr, Frank Jürgen et al**
**Diehl & Partner GbR**
**Augustenstrasse 46**
**80333 München (DE)**

(56) Entgegenhaltungen:
EP-A- 0 180 723    EP-A- 0 274 622
EP-A- 0 333 018    EP-A- 0 461 442

EP-A- 0 893 816    EP-A- 0 910 108
DE-A1- 19 845 329    US-A- 5 093 572
US-A- 5 731 586

- REIMER, LUDWIG: "Scanning Electron Microscopy" 1986, SPRINGER , BERLIN HEIDELBERG NEW YORK TOKYO , XP002493854 * Seite 1 *
- FROSIEN J ET AL: "High performance electron optical column for testing ICs with submicrometer design rules" MICROELECTRONIC ENGINEERING, ELSEVIER PUBLISHERS BV., AMSTERDAM, NL, Bd. 7, Nr. 2-4, 1. Januar 1987 (1987-01-01), Seiten 163-172, XP025931934 ISSN: 0167-9317 [gefunden am 1987-01-01]
- FROSIEN J ET AL: "COMPOUND MAGNETIC AND ELECTROSTATIC LENSES FOR LOW-VOLTAGE APPLICATIONS" JOURNAL OF VACUUM SCIENCE AND TECHNOLOGY: PART B, AVS / AIP, MELVILLE, NEW YORK, NY, US, Bd. 7, Nr. 6, 1. November 1989 (1989-11-01), Seiten 1874-1877, XP000117179 ISSN: 1071-1023
- KOLARIK V ET AL: "A design of a new axially symmetric secondary electron detector for the transmission electron microscope" MEASUREMENT SCIENCE AND TECHNOLOGY, IOP, BRISTOL, GB, Bd. 1, Nr. 5, 1. Mai 1990 (1990-05-01), Seiten 391-395, XP020066215 ISSN: 0957-0233
- DE JAGER P W H ET AL: "A combined objective lens for electrons and ions" MICROELECTRONIC ENGINEERING, ELSEVIER PUBLISHERS BV., AMSTERDAM, NL, Bd. 30, Nr. 1-4, 1. Januar 1996 (1996-01-01), Seiten 427-430, XP004597546 ISSN: 0167-9317

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

**Beschreibung**

Die Erfindung betrifft ein Elektronenmikroskopiesystem mit magnetischer und elektrostatischer Fokussierung und insbesondere eine Objektivlinse für ein solches System. Ferner betrifft die Erfindung ein Untersuchungssystem zum Abbilden und Manipulieren eines Objektes, welches ein solches Elektronenmikroskopiesystem umfaßt.

In einer Vielzahl von Fachbereichen und Anwendungsgebieten zeichnet sich ein zunehmender Trend zur Miniaturisierung ab. Insbesondere in der Halbleitertechnologie besteht Nachfrage an immer kleineren, komplexeren und leistungsstärkeren Bauelementen. Es besteht somit beispielsweise im Rahmen von Qualitätssicherung und Prozessanalyse ein Bedarf, die Wafer und darauf entstehende bzw. fertige Bauelemente optisch inspizieren zu können. Da die Größe der einzelnen Strukturen der Bauelemente im Mikrometerbereich und darunter liegt, werden üblicherweise Elektronenmikroskope verwendet, um eine notwendige Vergrößerung und Auflösung zu erzielen. Besonders vorteilhaft sind dabei solche Elektronenmikroskopiesysteme, welche eine Abbildung der zu untersuchenden Struktur unter einer großen Zahl von Beobachtungswinkeln zulassen, was bei zunehmender Wafergröße spezielle Anforderungen an die elektronenmikroskopische Anordnung stellt. Im Rahmen einer Charakterisierung einer Struktur, insbesondere einer Halbleiterstruktur, besteht eine Technik darin, einen Graben in die zu charakterisierende Struktur zu "fräsen", um einen Querschnitt durch die Struktur untersuchen zu können und so mit relativ geringem Arbeitsaufwand eine Fülle von Informationen, z.B. bezüglich Schichtenfolgen in der Struktur, erhalten zu können. Ein solcher Graben wird beispielsweise mit Hilfe eines fokussierten Ionenstrahls (focused ion beam, FIB) in die Halbleiterstruktur geätzt. Diese Ätzmethode ist besonders für die Herstellung von Probenquerschnitten für die Transmissionselektronenmikroskopie oder bei einer Struktur mit einer komplexen Schichtenfolge und unterschiedlicher Ätzselektivität der einzelne Schichten von Bedeutung. Verfahren unter Verwendung eines FIB erlauben die Herstellung recht feiner und wohldefinierter Schnitte. Es ist bei dieser Methode vorteilhaft, den Ätzvorgang in situ mikroskopisch beobachten können.

Aus dem Stand der Technik sind bereits verschiedene Elektronenmikroskopiesysteme sowie eine Zahl von in solchen Systemen anwendbaren Objektivlinsen bekannt. Eine solche Objektivlinse, die sich als vorteilhaft erwiesen hat, sieht eine Kombination aus magnetischer und elektrostatischer Fokussierung bzw. Verzögerung vor.

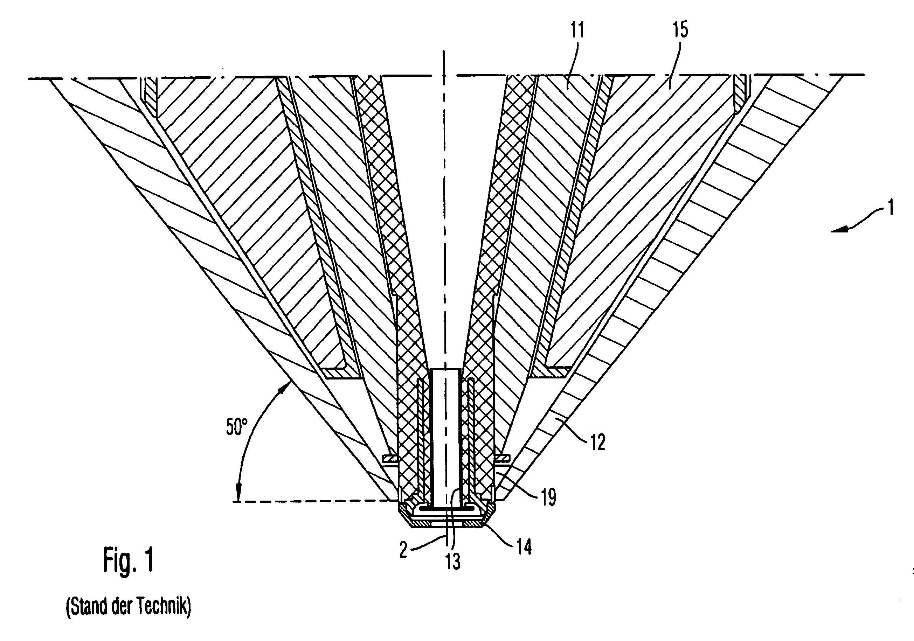

Ein Beispiel einer herkömmlichen Objektivlinse ist in Figur 1 schematisch dargestellt. Die Objektivlinse 1 umfaßt eine rotationssymmetrisch um eine optische Achse 2 der Objektivlinse angeordnete magnetische Linse mit einer Polschuhanordnung mit einem inneren Polschuh 11 und einem äußeren Polschuh 12 sowie mit einem in einem Raum zwischen innerem und äußerem Polschuh 11, 12 angeordneten Spulenkörper 15. Ferner umfaßt die Objektivlinse 1 eine elektrostatische Immersionslinse mit einem eine erste Elektrode bildenden Strahlrohr 13 und einer Abschlußelektrode 14. Das Strahlrohr 13 ist im Wesentlichen in einem unteren Teil eines durch den inneren Polschuh 11 gebildeten Innenraums angeordnet, während die Abschlußelektrode 14 sich räumlich im Wesentlichen in z-Richtung an den äußeren Polschuh anschließt. Werden die zwischen den Polschuhen angeordneten Spulenwindungen der magnetischen Linse von Strom durchflossen, so wird im inneren Polschuh 11 und im äußeren Polschuh 12 ein magnetischer Fluß induziert. Dabei führt das Polschuhmaterial einen großen Teil des Flusses. In einem Bereich eines axialen Polschuhspalts 19 tritt ein durch die Polschuhe 11, 12 geklammertes magnetisches Feld bis auf die optische Achse 2 aus. Magnetfeldstärke und Ausdehnung des Magnetfeldes auf der optischen Achse 2 sind für die Fokuslänge von Bedeutung. Dabei ist die Brennweite proportional zur Beschleunigungsspannung der Elektronen geteilt durch das Ortsintegral über das Quadrat der magnetischen Flußdichte im Bereich der Polschuhe entlang des z-Achse.

Am Strahlrohr 13 der elektrostatischen Linse wird eine positive Spannung angelegt, während die Abschlußelektrode 14 vorzugsweise auf Erdpotential geschaltet ist. Die elektrostatische Linse erzeugt ein Verzögerungsfeld, in dem die Elektronen des Elektronenstrahls vor Verlassen der Elektronenoptik abgebremst werden. Dies erlaubt, daß die Elektronen des Elektronenstrahls den größten Teil des Strahlengangs zwischen Elektronenquelle und elektrostatischer Linse mit hoher Energie bzw. Geschwindigkeit durchlaufen können und so sich auf die Fokussierung negativ auswirkende elektrostatische Abstoßungserscheinungen der gleich geladenen Elektronen minimieren lassen. Das elektrostatische Feld zwischen Strahlrohrende und Abschlußelektrode 14 weist ferner eine Inhomogenität derart auf, daß dieses Feld ebenfalls fokussierend auf die dieses durchlaufende Primärelektronen wirkt.

Weiterhin hat sich als günstig erwiesen, daß ein durch die Magnetlinse der Objektivlinse erzeugtes Magnetfeld auf der Oberfläche eines Objekts - beispielsweise im Vergleich mit sog. "single-pole"-Linsen - relativ gering ist. Wie in Figur 1 dargestellt, weist Objektivlinse 1 einen im Wesentlichen konischen äußeren Polschuh 12 mit einem Konuswinkel einer äußeren Seite des äußeren Polschuhs zur optischen Achse von 40° auf. Bedingt durch die Geometrie des äußeren Polschuhs 12 und den im Wesentlichen durch diese bestimmten Raumbedarf der elektronenmikroskopischen Linsenanordnung läßt sich ein zu untersuchendes Objekt bei einem kleinen Arbeitsabstand bis hin zu einem Winkel von 90° - 40° = 50° relativ zur optischen Achse des Elektronenmikroskopiesystems kippen.

Eine Elektronenmikroskopieanordnung, welche eine solche Objektivlinse umfasst, wurde ebenfalls vorteilhaft in einer Anordnung zum Abbilden und Manipulieren eines Objekts, die zusätzlich eine Vorrichtung zum Erzeugen und Steuern eines fokussierten Ionenstrahls (im folgenden auch als Ionenstrahlbearbeitungssystem oder FIB-Säule bezeichnet) aufweist, eingesetzt. Insbesondere ermöglicht es eine solche Anordnung, Abbilden und Bearbeiten der Struktur simultan auszuführen. Aufgrund des Raumbedarfs der obig beschriebenen Objektivlinse der elektronenoptischen Anordnung sowie der FIB-Säule kann ein zu untersuchendes flächig ausgedehntes Objekt bei simultanem Abbilden und Bearbeiten maximal bis zu einem Winkel von 80° relativ zum Ionenstrahl angeordnet werden. Somit lassen sich in einem eine solche herkömmliche Objektivlinse umfassenden System mit Hilfe des FIB keine Gräben mit vertikalen Wänden in einem Objekt bei simultaner Abbildung durch das Elektronenmikroskop erzeugen. Vielmehr wird nach einem Arbeitsschritt zur Bearbeitung des Objekts durch den FIB das Objekt gekippt und verdreht, und anschließend die durch den FIB erzeugte Struktur abgebildet.

Bei gleichzeitigem Betreiben von Elektronenmikroskopieanordnung und fokussiertem Ionenstrahl ist allgemein ein Magnetfeld im Bereich des durch den Ionenstrahl manipulierten Objekts zu minimieren, da die Ionen durch das Magnetfeld abgelenkt werden, was zu einer Beeinträchtigung der Bearbeitungspräzision des fokussierten Ionenstrahls führt. Ferner kann in einem solchen Magnetfeld eine Aufspaltung des Ionenstrahls nach Isotopen auftreten, was eventuell dessen Verwendbarkeit ganz ausschließt.

Aus den Dokumenten DE 198 45 329 A1, EP 0 910 108 A1 und US 5,731,586 sind verschiedene Bauformen von Objektivlinsen für Elektronenmikroskope bekannt. Insbesondere zeigt die Figur 3 des Dokuments US 5,731,586 eine Objektivlinse für ein Elektronenmikroskopiesystem mit magnetischer und elektrostatischer Fokussierung mit einer Polschuhanordnung zur Erzeugung eines fokussierenden Magnetfeldes mit einem inneren Polschuh und einem äußeren Polschuh und einer Elektrodenanordnung zur Erzeugung eines fokussierenden elektrostatischen Feldes mit einem den inneren Polschuh durchsetzenden Strahlrohr und einer mit Abstand von einem unteren Ende des Strahlrohrs angeordneten Abschlusselektrode.

Es ist eine Aufgabe der vorliegenden Erfindung, eine Objektivlinse für ein Elektronenmikroskopiesystem vorzuschlagen, welches einen verringerten Raumbedarf und insbesondere einen verringerten Winkel zwischen einer optischen Achse der Objektivlinse und einem Außenrand des konischen äußeren Polschuhs aufweist.

Diese Aufgabe wird gelöst durch eine Objektivlinse mit den Merkmalen des beigefügten Patentanspruchs 1. Vorteilhafte Ausgestaltungen dieser Objektivlinse sind in den beigefügten Patentansprüchen 2 bis 16 dargelegt. Ferner wird ein Untersuchungssystem mit den Merkmalen des Patentanspruchs 17 vorgeschlagen, welches diese Objektivlinse enthält.

Die Objektivlinse für ein Blektronenmikroskopiesystem mit magnetischer und elektrostatischer Fokussierung zum Abbilden eines in einer Objektebene anordenbaren Objektes umfasst:

- eine Polschuhanordnung zur Erzeugung eines fokussierenden Magnetfeldes, welche bezüglich einer sich in einer z-Richtung erstreckenden optischen Achse der Objektivlinse im wesentlichen rotationssymmetrisch ist und einen inneren Polschuh und einen äußeren Polschuh aufweist,
  wobei an einer in z-Richtung untersten Stelle des inneren Polschuhs, wo dieser von dem äußeren Polschuh einen in z-Richtung orientierten Spaltabstand aufweist, zwischen dem inneren und dem äußeren Polschuh ein Polschuhspalt ausgebildet ist,

- eine Elektrodenanordnung zur Erzeugung eines fokussierenden elektrostatischen Feldes, welche bezüglich der optischen Achse im wesentlichen rotationssymmetrisch ist, und umfasst: ein Strahlrohr, welches den inneren Polschuh entlang der optischen Achse durchsetzt und ein unteres Ende aufweist, und weiterhin eine mit Abstand von dem unteren Ende des Strahlrohrs angeordnete Abschlußelektrode,

- wobei für die Objektivlinse in einem Bereich innerhalb von wenigstens 3 cm um den Polschuhspalt herum gilt:

  - der innere Polschuh verjüngt sich wenigstens bereichsweise (in z-Richtung) nach unten und weist dort einen inneren Konuswinkel $\beta$ und einen äußeren Konuswinkel $\chi$ zur z-Richtung auf,

  - der äußere Polschuh erstreckt sich nach unten, insbesondere verjüngt er sich hierbei wenigstens bereichsweise, und weist unten einen inneren Konuswinkel $\Delta$ und einen äußeren Konuswinkel $\alpha$ zur z-Richtung auf, und dadurch gekennzeichnet, daß weiterhin die Objektivlinse dazu ausgebildet ist, daß

  - ein Arbeitsabstand $W_D$ zwischen der Abschlußelektrode und der Objektebene für Elektronen, die das Strahlrohr mit etwa 30 keV durchlaufen, kleiner als oder gleich 2 mm ist,

  und daß weiterhin gilt:

  - $30° < \alpha < 35°$ und $10° < \Delta-\chi < 14°$.

Die Objektivlinse umfasst weiterhin einen in einem Raum zwischen dem inneren und dem äußeren Polschuh angeordneten Spulenkörper.

Im Wesentlichen wurden Geometrie und Anordnung der Komponenten der herkömmlichen Objektivlinse verändert, um unter einem ersten Aspekt so den Winkel zwischen konischem äußeren Polschuh und z-Achse verringern zu können und damit den Raumbedarf der Objektivlinse und damit elektronenmikroskopischen Anordnung zu verringern. Dadurch kann ein im Wesentlichen flächig ausgedehntes Objekt bezüglich der optischen Achse der Elektronenmikroskopieanordnung stärker gekippt werden.

Die vorgeschlagene Änderung der Geometrie der herkömmlichen Objektivlinse, die zu einer die Aufgabe(n) lösenden Objektivlinse mit für das Elektronenmikroskopiesystem zufriedenstellenden optischen Parametern führt, ist dabei für den Fachmann nicht naheliegend, sondern aus einer Reihe von Gründen überraschend, wie nachfolgend dargestellt:

In der magnetischen Linse der Objektivlinse sollen der innere und der äußere Polschuh den gesamten magnetischen Fluß führen, so daß das magnetische Feld im Wesentlichen nur für die kurze Strecke des Polschuhspalts aus diesen austritt. Weiterhin ist eine magnetische Sättigung des die Polschuhe ausbildenden Materials zu vermeiden, da eine solche Sättigung zu unreproduzierbaren und nicht rotationssymmetrischen Magnetfeldern und zu einer Verdrängung des Magnetflusses aus den Polschuhen heraus führen würde. Eine Fokussierung energiereicher Elektronenstrahlen würde im Falle einer Polschuhmaterialsättigung aufgrund des abgeschwächten Magnetfeldes beeinträchtigt. Daher würde eine Verringerung des Raumbedarfs der Magnetlinse durch eine Verringerung der Dicke der Polschuhe und damit Materialabtrag unter Beibehaltung der zur magnetischen Anregung durch die zwischen den Polschuhen angeordneten Spule verwendeten Parameter eine vorzeitige magnetische Sättigung des Materials und damit unzureichendes Fokussierungsvermögen der Objektivlinse erwarten lassen. Versuchte man, die Magnetlinse durch Verringerung des Abstandes, d.h. der Winkeldifferenz von innerem und des äußerem Polschuh zu verkleinern, würde diese Verringerung zu magnetischem Kurzschluß und damit zu nachteiligen Störungen des Magnetfeldes, insbesondere Verschiebungen, Verformungen und Abschwächungen des Feldes entlang der optischen Achse, führen. Außerdem würde dadurch der für die Spule zur Verfügung stehende Raum verkleinert, infolgedessen müßte zum Erhalt der zu einer genügenden Erregung notwendigen Anzahl der Windungen der Spule ein kleinerer Drahtdurchmesser für den für die Spule verwendeten Draht gewählt werden. Der mit einem kleineren Drahtdurchmesser verbundene höhere Ohm'sche Widerstand würde jedoch die von dem Draht der Spule erzeugte Wärmemenge erhöhen, was zur Vermeidung räumlicher Drifterscheinungen eine aufwendigere Kühlung als die verwendete Wasserkühlung erforderlich machen würde. Daher scheinen Materialabtrag an den Polschuhen und/oder eine Verringerung des Abstandes des inneren und äußeren Polschuhs keine geeignete Maßnahmen zur Lösung der Aufgabe zu sein.

Zusammen mit einer Verringerung des Winkels $\alpha$ zwischen der Außenseite des äußeren Polschuhs und einer Verringerung der Dicken der Polschuhe wurde auch eine Anordnung der Polschuhe zueinander, insbesondere die Differenz des Winkels zwischen dem äußeren Winkel $\chi$ des inneren Polschuhs zur z-Achse und dem inneren Winkel $\Delta$ des äußeren Polschuhs zur z-Achse, und die Abmessung des Polschuhspalts bzw. -abstands, in nicht durch den Stand der Technik nahegelegter Weise abgewandelt, um zu einer überraschend leistungsfähigen Objektivlinse zu gelangen:

Zumindest in einem Bereich innerhalb von etwa 3cm um den Polschuhspalt liegt $\alpha$ erfindungsgemäß in einem Bereich von 30° bis 35°, die Differenz $\Delta$-$\chi$ in einem Bereich von 10° bis 14°, wobei mit dieser Anordnung bei Verwendung von Elektronen, die das Strahlrohr mit etwa 30 keV durchlaufen, ein Arbeitsabstand zwischen der Abschlußelektrode und der Objektebene kleiner als oder gleich 2 mm erreicht wird.

Der Arbeitsabstand ist hier als Abstand zwischen einem untersten Bereich bzw. einem unteren Ende der Abschlusselektrode und der Objektebene bzw. einem in diese angeordneten Objekt zu verstehen, wobei bei diesem Arbeitsabstand bei bestimmungsgemäßem Gebrauch eine auflösungsbeste Abbildung erzielt werden kann bzw. eine Auflösung erzielt werden kann, die nicht wesentlich verschieden ist von der spezifizierten Auflösung beim bestimmungsgemäßen Gebrauch.

Die Objektivlinse kann jedoch auch bei Verwendung größerer Arbeitsabstände vorteilhaft eingesetzt werden.

Besonders bevorzugt ist eine Anordnung, in der $\alpha$ = 34° und $\Delta$-$\chi$ = 13°.

An einer in z-Richtung untersten Stelle des inneren Polschuhs weist dieser von dem äußeren Polschuh einen in z-Richtung orientierten Spaltabstand auf, wo zwischen dem inneren und dem äußeren Polschuh ein Polschuhspalt ausgebildet ist. Im Bereich des Polschuhspalts tritt das Magnetfeld in Richtung der optischen Achse aus. Die Abmessungen des Polschuhspalts haben Einfluß auf die Stärke wie auch die räumliche Ausdehnung des magnetischen Feldes auf der optische Achse und damit auf die Fokuslänge der Objektivlinse. Bei der Optimierung der Polschuhgeometrie sind die Eigenschaften der sphärischen und chromatischen Aberration gegenüber der Fokussierleistung, die durch die Feldabflachung aufgrund von Materialsättigung oder zu großer Spaltbreite verringert wird, abzuwägen. Es wird ein Polschuhspaltabstand von mindestens 3 mm gewählt. Bei der Angabe dieses Abstandes ist zu beachten, daß es sich hier gewissermaßen um einen effektiven Polschuhspaltabstand handelt. Das bedeutet, daß es möglich ist, durch Hinzufügen weiteren Materials in Form beispielsweise eines dünnen Fortsatzes oder dünner Filme oder Folien den Polschuhspalt bzw. Polschuhabstand zwar unter einem geometrischen, nicht jedoch unter einem funktionellen Aspekt zu verkleinern. Durch dieses hinzugefügte Material werden nämlich infolge magnetischer Sättigung im hinzugefügten Material das von der Magnetlinse erzeugte Magnetfeld und damit die von dem inneren und äußeren Polschuh ausgehenden magnetischen Feldlinien nicht wesentlich beeinflußt, oder das Material wird an einer Stelle hinzugefügt, an der sich ohnehin kaum noch Fluß im Polschuh befindet.

In einer vorteilhaften Ausgestaltung der Erfindung erweitern sich eine innere und eine äußere Seite des inneren Polschuhs von einem in z-Richtung untersten Punkt des inneren Polschuhs in einer konischen Form nach oben. In einer alternativen, bevorzugten Ausführungsform ist der innere Polschuh derart ausgebildet, daß er sich von seinem unteren Ende in Form eines Zylindermantels etwa 1 mm bis 3 mm in z-Richtung nach oben erstreckt, bevor er sich dann zumindest auf einer äußeren Seite konisch erweitert. Bevorzugt verjüngt sich der äußere Polschuh nach unten.

Vorzugsweise weist der innere Polschuh zumindest an seinem unteren Ende einen Innendurchmesser von 6 mm bis 8 mm auf, wobei ein Innendurchmesser von 7,5 mm besonders bevorzugt ist.

Die Abmessung des radial innersten, axial um die Achse angeordneten untersten Bereichs des äußeren Polschuhs liegt bevorzugt in einem Bereich von 0,5 mm bis 3 mm, die Abmessung des radial innersten, axial um die Achse angeordneten untersten Bereichs des inneren Polschuhs beträgt bevorzugt 10 mm und mehr.

Damit wurde, entgegen den Erwartungen des Fachmanns, sowohl Material von den Polschuhen entfernt sowie eine Winkeldifferenz zwischen den Polschuhen verringert, wobei trotz größerem Spaltabstand ein Arbeitsabstand von 2 mm und kleiner erreicht wird.

In besonders bevorzugten Ausführungsformen ist ein in z-Richtung unteres Ende der Abschlußelektrode von einem in z-Richtung untersten Bereich des äußeren Polschuhs in z-Richtung mit Abstand angeordnet.

Besonders bevorzugt ist das Strahlrohr derart angeordnet, daß es eine durch einen in z-Richtung untersten Bereich des äußeren Polschuhs gebildete Öffnung des äußeren Polschuhs zumindest durchsetzt. In besonders bevorzugten Ausführungsformen durchsetzt das Strahlrohr die Öffnung des äußeren Polschuhs und ist das untere Ende des Stahlrohrs derart angeordnet, daß es in z-Richtung von der Öffnung des äußeren Polschuhs mit Abstand angeordnet ist, d.h. parallel zur optischen Achse verlaufend aus der Polschuhanordnung, insbesondere der Öffnung des äußeren Polschuhs heraustritt. Besonders bevorzugt ist also das untere Ende des Strahlrohrs in z-Richtung zwischen der Öffnung des äußeren Polschuhs und dem unteren Ende der Abschlußelektrode angeordnet.

Gemäß Ausführungsformen der Erfindung zeichnet sich eine Objektivlinse, ergänzend zu der obig beschriebenen besonderen geometrischen Ausgestaltung der durch die Polschuhanordnung ausgebildeten Magnetlinse (einschließlich der bevorzugten Ausführungsformen), durch eine magnetische Kopplung des äußeren Polschuhs und der Abschlußelektrode aus. Diese magnetische Kopplung wird dadurch erreicht, daß der äußere Polschuh, welcher nach außen im wesentlichen durch eine Konusfläche mit einem Konuswinkel ($\alpha$) zur z-Richtung begrenzt ist, und die Abschlußelektrode, welche nach außen im Wesentlichen durch eine Konusfläche mit einem Konuswinkel ($\alpha'$) zur z-Richtung begrenzt ist, zum Reduzieren des Magnetfelds auf dem in der Objektebene anordnenbaren Objekt im wesentlichen spaltfrei magnetisch miteinander gekoppelt sind. Diese magnetische Kopplung bewirkt eine bessere Abschirmung des Magnetfeldes zu Bereichen außerhalb der Objektivlinse hin, was besonders vorteilhaft ist in Fällen, wo das Magnetfeld mit dem Objekt bzw. einer Probe störend interferiert oder auch bei der gleichzeitigen Bearbeitung des untersuchten Objekts mit Hilfe eines fokussierten Ionenstrahls, da das Magnetfeld die Ionen ablenken und damit den Bearbeitungsvorgang stören würde.

Besonders bevorzugt ist die Objektivlinse auch unter diesem Aspekt dazu ausgebildet, daß ein Arbeitsabstand kleiner als 2 mm ist für Elektronen, die das Strahlrohr mit etwa 30 keV durchlaufen.

In einer besonders bevorzugten Ausführungsform wird die magnetische Kopplung zwischen Abschlußelektrode und äußerem Polschuh dadurch erreicht, daß ein Spalt zwischen der Abschlußelektrode und dem äußeren Polschuh kleiner als 0,6 mm und noch mehr bevorzugt kleiner als 0,2 mm ist. Ein solcher Spalt zwischen Abschlußelektrode und äußerem Polschuh wird vorteilhaft dadurch ausgebildet, daß sich ein Bereich der Abschlußelektrode und ein Bereich des äußeren Polschuhs flächig gegenüberliegen.

Besonders bevorzugt liegen sich ein in z-Richtung oberster Bereich der Abschlusselektrode und der in z-Richtung unterste Bereich des äußeren Polschuhs flächig gegenüber, wobei bevorzugt die sich gegenüberliegenden Flächen parallel zur z-Richtung angeordnet sind, und weiter bevorzugt zumindest der dem äußeren Polschuh flächig gegenüberliegende Bereich der Abschlusselektrode innerhalb der durch den in z-Richtung untersten Bereich des äußeren Polschuhs gebildeten Öffnung angeordnet ist.

Besonders bevorzugt wird die Abschlußelektrode durch eine sich von einem unteren Bereich des äußeren Polschuhs aus entlang der Innenseite des inneren Polschuhs erstreckenden Kunststoffisolierung sowie elektrisch isolierte Klammern gehalten. Dies ermöglicht es insbesondere, die Abschlußelektrode, welche durch einen Spalt elektrisch isoliert von dem äußeren Polschuh ist, auf ein anderes Potential als Erdpotential schalten zu können, was für verschiedene Anwendungen vorteilhaft ist. Weiterhin erlaubt dies, die Abschlußelektrode unabhängig vom äußeren Polschuh austauschen zu können.

Weiter bevorzugt ist eine Anordnung von äußerem Polschuh und Abschlußelektrode, in der die sich zumindest teilweise im Wesentlichen konisch erstreckenden Außenseiten des äußeren Polschuhs und der Abschlußelektrode miteinander fluchten.

Die Abschlußelektrode ist vorteilhaft derart gestaltet, daß sie sich bis zu einer zentralen Öffnung am unteren Ende der Abschlußelektrode hin im Wesentlichen konisch verjüngt und so das elektrostatische Feld vergleichsweise nahe an einem Objekt bzw. einer Probe bereitgestellt wird. Da die Abschlußelektrode vorzugsweise auf Erdpotential geschaltet ist, ist in einem Bereich der Probe das elektrostatische Feld jedoch vernachlässigbar klein. Die Nähe des Feldes zur Probe ist insbesondere bei größeren Arbeitsabständen $W_D$, d.h. Abständen zwischen Abschlußelektrode und Probenoberfläche, von Vorteil. Der Innendurchmesser der zentralen Öffnung der Abschlußelektrode entspricht im wesentlichen einem Innendurchmesser des Strahlrohrs, es sind aber auch Ausführungsformen vorgesehen, in denen die zentrale Öffnung am unteren Ende der Abschlußelektrode einen anderen Innendurchmesser aufweist als der Innendurchmesser des Strahlrohrs.

Gemäß weiteres Ausführungsformen der Erfindung ist die elektrostatische Linse der Objektivlinse, ergänzend zu den obig beschriebenen besonderen geometrischen Parametern der Magnetlinse und/oder magnetischen Kopplung von äußerem Polschuh und Abschlusselektrode einschließlich der in Zusammenhang mit diesen beschriebenen bevorzugten Ausführungsformen, derart ausgestaltet, daß ein Abstand $A_1$ zwischen dem unteren Ende des inneren Polschuhs und dem unteren Ende bzw. der in z-Richtung untersten Stelle des Strahlrohrs größer als 9 mm und weiter bevorzugt größer als 10 mm ist. Diese Ausgestaltung ist besonders bevorzugt zum Reduzieren des Magnetfeldes in der Objektebene vorgesehen. Besonders bevorzugt und besonders vorteilhaft ist bei dieser Ausgestaltung das untere Ende des Strahlrohrs in z-Richtung zwischen unterstem Bereich des äußeren Polschuhs und dem unteren Ende der Abschlusselektrode angeordnet. In einer besonders bevorzugten Ausführungsform ist ein Abstand $A_2$ zwischen dem unteren Ende des Strahlrohrs und dem unteren Ende der Abschlußelektrode größer als 3 mm, besonders bevorzugt ist ein Abstand von etwa 6 mm.

Dieser Anordnung liegt die Idee zugrunde, eine Überlappung des durch die Magnetlinse erzeugten Magnetfeldes und des durch die Abschlußelektrode und Strahlrohr umfassende elektrostatische Linse erzeugten elektrostatischen Feldes gegenüber der aus dem Stand der Technik bekannten Anordnung zu verkleinern. Insbesondere überlappen das elektrostatische und das magnetische Feld bei einer solchen Linsengeometrie bevorzugt um weniger als 5% (bezogen auf die Feldintegrale). Damit weist das durch die magnetische Linse erzeugte Magnetfeld einen größeren Abstand zu einem abzubildenden Objekt auf, wodurch ein Magnetfeld in der Objektebene bzw. auf dem Objekt minimiert wird. Gründe, warum diese Feldminimierung auf dem Objekt vorteilhaft ist, wurden bereits zuvor angesprochen. Ein weiterer Vorteil dieser Anordnung liegt darin, daß das elektrostatische Feld nahe zur Probe angeordnet ist, was besonders bei größeren Arbeitsabständen vorteilhaft ist.

Besonders bevorzugt weist das untere Ende des Strahlrohrs einen Endflansch auf, welcher sich radial über einen Außendurchmesser des Strahlrohrs hinaus erstreckt. Dabei weist der das Strahlrohr umschließende Endflansch einen Abstand zu der Abschlußelektrode auf, welcher groß genug ist, um ein Auftreten elektrischer Überschläge oder Kurzschlüsse zu verhindern. Dieser Endflansch ist vorzugsweise derart ausgebildet, daß er im Axialquerschnitt von einem in Richtung der Objektebene weisenden Frontabschnitt zu einem Mantelabschnitt in verrundeter Form übergeht, wobei diese Verrundung einen Krümmungsradius von mindestens einem Millimeter aufweist. Dieser besonderen Ausgestaltung des Strahlrohrs liegt die Idee zugrunde, im Bereich im Wesentlichen zwischen innerem Polschuh und Strahlrohr angeordnete, aus Kunststoff gefertigte Komponenten der Objektivlinse vor einer Aufladung durch eine beim Betreiben der Elektronenmikroskopieanordnung unausweichlich auftretenden Elektronenwolke zu schützen, indem gewissermaßen der direkte Zugang zu diesem Bereich durch die Abschirmung durch den Endflansch erschwert wird und der Primärelektronenstahl ähnlich wie durch einen Faraday'schen Käfig abgeschirmt wird. Der Endflansch kann auch derart ausgestaltet sein, daß ein Übergang von der den Innendurchmesser begrenzenden Innenwand des Strahlrohrs zur Frontfläche verrundet ausgebildet ist.

Bei allen obig angeführten Ausgestaltungen wird für die Polschuhe vorzugsweise ein Material gewählt, das eine hohe Sättigungsmagnetisierung aufweist. Besonders bevorzugt wird für die Polschuhe eine Eisen-Nickel-Legierung mit einem Nickel-Gehalt von 45% bis 50% verwendet. Besonders bevorzugt ist eine NiFe-Legierung mit dem Handelsnamen "Permenorm 5000 H3", kommerziell erhältlich von der Vacuumschmelze Hanau, Deutschland. Vorteilhaft können auch eine Cobalt-Eisen-Vanadium-(49%Co-49%Fe-2%V)-Legierung, Cobalt-Eisen-Legierungen (z.B. 30% Co, 70% Fe) oder Weicheisen verwendet werden.

Das für den Spulenkörper verwendete Material umfasst vorzugsweise Kupferdraht. Der Spulenkörper ist thermisch von den Polschuhen isoliert, wobei bei Stromdurchfluß in dem Spulenkörper generierte Wärme von einem thermisch mit dem Spulenkörper gekoppelten, im Innenraum zwischen dem innern und dem äußeren Polschuh angeordneten Wasserkühlungsrohr aufgenommen und durch den Kühlkreislauf abtransportiert wird.

Für die Abschlußelektrode wird bevorzugt ein sogenanntens µMetall (Mumetall®), d.h. eine Nickel-Eisen-Legierung mit einem Nickel-Anteil von 72 - 89%, gewählt, besonders bevorzugt Hyperm 766.

Bevorzugt sind in der Objektivlinse weiterhin mehrere Ablenkspulen zum Ablenken des Elektronenstrahls vorgesehen, so daß der Elektronenstrahl über einen definierten Bereich einer Objektoberfläche rastern kann. Neben der voranstehend beschriebenen Objektivlinse umfasst ein Elektronenmikroskopiesystem weitere Komponenten: eine Probenkammer, in der ein zu untersuchendes Objekt angeordnet ist, eine Elektronenstrahlquelle zum Erzeugen und Beschleunigen eines Elektronenstrahls, Elektronenoptik mit einer oder mehreren elektrostatischen und/oder magnetischen Linse(n), zumindest ein Vakuumsystem zum Evakuieren zumindest der vom Elektronenstrahl durchsetzten Räume des Elektronenmikroskops und der Probenkammer, eine Objekthalterung in der Probenkammer zum Anordnen und Ausrichten eines Objekts vor dem Elektronenmikroskop und zumindest einen Detektor zum Detektieren von Elektronen, insbesondere Sekundärelektronen. In einer bevorzugten Elektronenmikroskopieanordnung ist zumindest ein Detektor in einem Innenraum des Elektronenmikroskops, welcher in z-Richtung oberhalb der Objektivlinse angeordnet ist, vorgesehen.

Unter einem zusätzlichen Aspekt stellt die Erfindung ein Untersuchungssystem zur Beobachtung und zur Manipulation eines zu untersuchenden Objekts bereit, welches folgende Komponenten umfaßt:

- ein Elektronenmikroskopiesystem mit einer Objektivlinse gemäß obiger Beschreibung,

- ein Ionenstrahlbearbeitungssystem zum Manipulieren des Objekts mittels eines emittierten Ionenstrahls,

- eine Objekthalterung zur Halterung und Ausrichtung des Objekts vor dem Ionenstrahlbearbeitungssystem und dem Elektronenmikroskopiesystem, mit der ein flächig ausgedehntes Objekt derart vor dem Elektronenmikroskopiesystem ausrichtbar ist, daß der Ionenstrahl die Objektoberfläche orthogonal schneidet.

Große Vorteile ergeben sich aus einer Kombination des voranstehend beschriebenen Elektronenmikroskopiesystems mit einem Ionenstrahlbearbeitungssystem. Das Ionenstrahlbearbeitungssystem ist zur Erzeugung und Lenkung eines fokussierten Ionenstrahls vorgesehen, mit Hilfe dessen ein zu untersuchendes Objekt beispielsweise durch Abtragen von Material aus einem definierten Bereich der Oberfläche des Objekts manipuliert wird. Neben der Möglichkeit zur Untersuchung von Objekten z.B. in Hinblick auf deren Topographie besteht auch die Möglichkeit, Reparaturarbeiten an lithographischen Masken oder direktschreibende Lithographieverfahren unter Verwendung dieser Anordnung auszuführen. Es sind darüber hinaus weitere Anwendungsmöglichkeiten denkbar. Das Ionenstrahlbearbeitungssystem umfaßt zum Erzeugen eines Ionenstrahls eine Ionenquelle, für die häufig eine Flüssigmetall-Ionenquelle (häufig Gallium oder Indium) verwendet wird sowie eine Extraktionselektrode zum Extrahieren von Ionen aus der Ionenquelle durch Anlegen eines elektrostatischen Feldes. Weiterhin umfaßt eine Ionenoptik des Ionenstrahlbearbeitungsystems zum Beschleunigen, Fokussieren und Führen bzw. Ablenken des Ionenstrahls zumindest eine Beschleunigungselektrode, elektrostatische Linsen, eine variable Apertur und Ablenkeinheiten.

Das Elektronenmikroskopiesystem und das Ionenstrahlbearbeitungssystem sind derart zueinander angeordnet, daß sich ihre optischen Achsen im Wesentlichen in einer durch eine Oberfläche des zu untersuchenden Objekts definierten Ebene schneiden. Das Objekt wird von einer Objekthalterung gehalten, die eine definierte Ausrichtung des Objekts vor Elektronenmikroskopiesystem und Ionenstrahlbearbeitungssystem erlaubt. So läßt sich der Winkel, unter dem der fokussierte Ionenstrahl und der fokussierte Elektronenstrahl auf der Objektoberfläche auftreffen, in einem definierten Winkelbereich einstellen. Dies erlaubt beispielsweise das Erzeugen von Löchern und Gräben mit unterschiedlich steilen Seitenwänden. Insbesondere läßt sich der Ionenstrahl senkrecht zum Objekt anordnen und ermöglicht daher das Erzeugen von Gräben mit senkrechten Seitenwänden, welchen für bestimmte Anwendungsbereiche eine große Bedeutung zukommen.

Nachfolgend werden Ausführungsbeispiele der Erfindung anhand von Figuren näher erläutert. Hierbei zeigt

Figur 1     eine Querschnittsansicht durch einen unteren Teil einer herkömmlichen Objektivlinse für ein Elek- tronenmikroskopiesystem,

Figur 2     eine Illustration der in der Beschreibung defi- nierten Winkel und Abmessungen im Bereich eines Polschuhspalts der Objektivlinse,

Figur 3     eine Querschnittsansicht durch ein Ausführung- beispiel der erfindungsgemäßen Objektivlinse,

Figur 4     einen vergrößerten Ausschnitt aus Figur 3,

Figur 5     einen vergrößerten Ausschnitt aus Figur 3 bzw. 4,

Figur 6    ein Diagramm der für ein Polschuhmaterial eines Ausführungsbeispiels der erfindungsgemäßen Objek- tivlinse charakteristischen Parameter Feldstärke und Flußdichte,

Figur 7    ein Diagramm der Überlagerung eines elektrostatischen und magnetischen Felds in einem Ausführungsbeispiel der erfindungsgemäßen Objektivlinse, und

Figur 8    eine schematische Darstellung eines erfindungsgemäßen Untersuchungssystems zum Abbilden und Manipulieren eines Objekts.

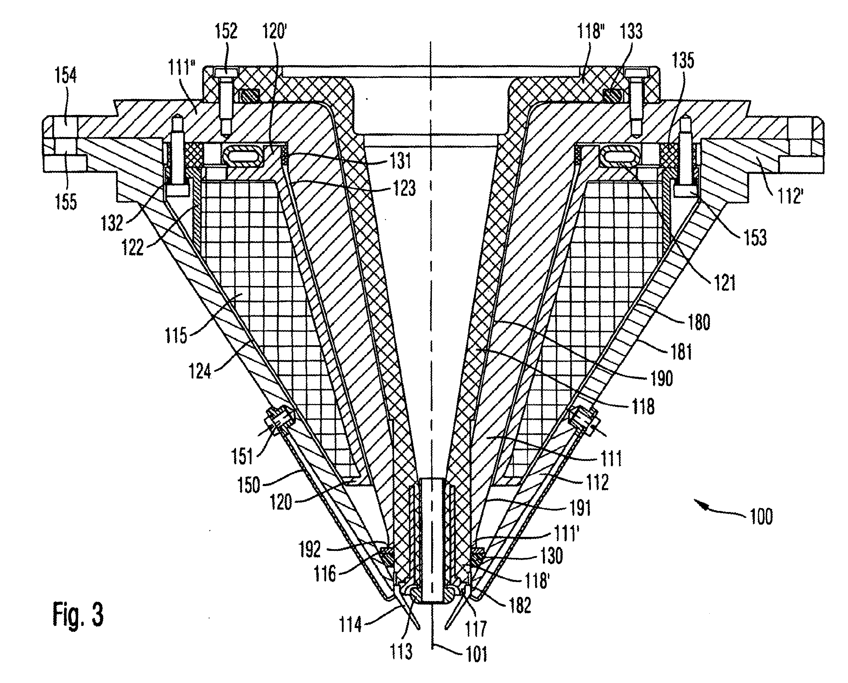

Eine in Figuren 3, 4 und 5 dargestellte Objektivlinse 100 dient zur Fokussierung eines Elektronenstrahls in einer Elektronenmikroskopieanordnung. Die Objektivlinse 100 umfaßt eine Magnetlinse sowie eine elektrostatische Linse, folglich erfolgt die Fokussierung sowohl elektrostatisch wie auch magnetisch. Die elektrostatische Linse dient auch zum Abbremsen der Elektronen des Primärelektronenstrahls. Die Magnetlinse umfaßt eine Polschuhanordnung mit einem inneren Polschuh 111 und einem äußeren Polschuh 112. Beide Polschuhe 111, 112 sind eine zentrale optische Achse 101, d.h. den Strahlengang eines Primärelektronenstrahls umschließend rotationssymmetrisch ausgebildet.

Der innere Polschuh 111 weist in z-Richtung im Wesentlichen eine konische Form auf und verjüngt sich in diesem konusförmigen Bereich kontinuierlich in Richtung zur Objektebene hin. In einem in z-Richtung untersten Bereich des inneren Polschuhs 111 weist dieser einen sich in z-Richtung über etwa 2,2 mm erstreckenden hohlzylinderförmigen Bereich 111' auf. Die innere Seite 190 des inneren Polschuhs 111 verläuft von einer in z-Richtung untersten Stelle 192 zunächst über etwa 32 mm hinweg parallel zur Achse 101 und erstreckt sich dann entlang einem Konus mit einem Winkel $\beta$ von 10,5° zur z-Achse, bis dieser in einen Radialflansch 111'' übergeht, der in seinem äußeren Bereich einem Radialflanschbereich 112' des äußeren Polschuhs 112 gegenüberliegt. Die äußere, von der Achse 101 weiter entfernte Fläche 191 des inneren Polschuhs 111 verläuft lediglich in dem hohlzylinderförmigen Bereich 111' etwa über 2,2 mm parallel zur optischen Achse und geht dann in einen Konus mit einem Winkel $\chi$ von 16° zur z-Achse über, bis dieser in einen Radialflanschteil 111" des inneren Polschuhs 111 übergeht.

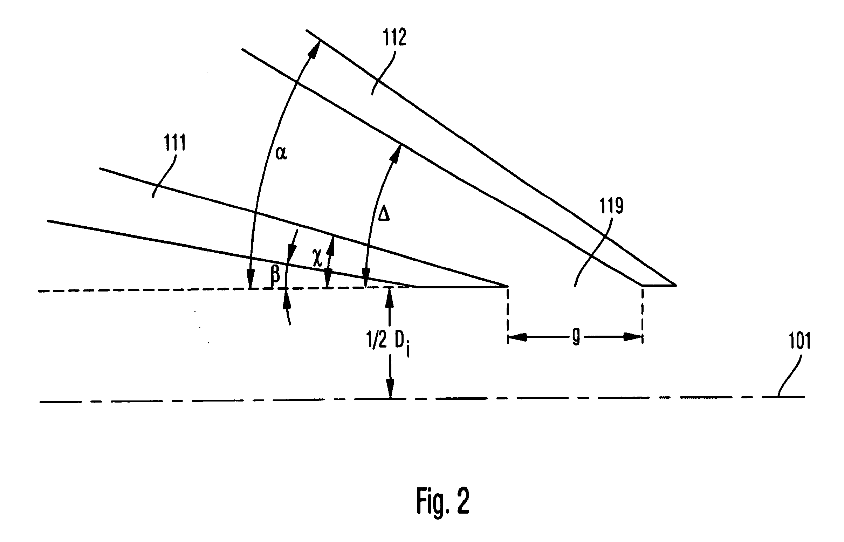

Der äußere Polschuh 112 erstreckt sich bis zu einem oberen Flanschbereich 112' im Wesentlichen konisch in z-Richtung. Dabei bildet eine innere Seite 180 des äußeren Polschuhs 112 in diesem konischen Bereich einen Winkeln von 29° zur Achse 101 aus, während eine äußere Seite 181 sich unter einem Winkel $\alpha$ von 34° zur Achse 101 nach radial außen erstreckt. An einer untersten Stelle 182 des äußeren Polschuhs 112 weist dieser eine zentrale Öffnung auf, deren Innendurchmesser im Wesentlichen gleich dem Innendurchmesser $D_i$ (vgl. Figur 2) der Öffnung an der in z-Richtung untersten Stelle 192 im inneren Polschuh 111 entspricht.

Aufgrund der unterschiedlichen Konusöffnungswinkel des inneren und des äußeren Polschuhs (111, 112) nimmt ein Abstand der beiden Polschuhe in Richtung zur Objektebene hin ab und erreicht in einem unteren Bereich 111' des inneren Polschuhs 111 eine kleinste Dimension. Zwischen der untersten Stelle 192 des inneren Polschuhs 111 und der untersten Stelle 182 des äußeren Polschuhs 112 wird ein parallel zur z-Richtung verlaufender, axialer Polschuhspalt 119 mit einem Polschuhabstand ausgebildet. Der Polschuhspalt 119 hat in dieser Ausführungsform eine axiale Länge von etwa 6 mm.

Die Anordnung und Ausgestaltung des Polschuhspalts 119 ist für die Funktion der Magnetlinse von großer Bedeutung. Die Polschuhe 111, 112 "klammern" in gewisser Weise das magnetische Feld. Die Feldlinien verlaufen zwischen dem oberen und dem unteren Polschuh in bauchig in Richtung optischer Achse 101 ausgewölbter Form. Eine maximale Feldstärke auf der optischen Achse 101 wird im Bereich des Polschuhspalts 119 erreicht, wobei die Feldstärke des erzeugten magnetischen Feldes im Wesentlichen in z-Richtung eine Glockenform aufweist.

In der in Figur 3 dargestellten Ausführungsform ist an dem untersten Ende 192 des inneren Polschuhs 111 im Polschuhspalt 119 ein flacher Stützring 116 aus nicht-magnetischem Material angeordnet, der den gleichen Innendurchmesser wie der hohlzylinderförmige Bereich 111' des inneren Polschuhs 111, jedoch einen größeren Außendurchmesser aufweist.

Im Polschuhspalt 119 ist weiterhin ein aus elastischem Material gefertigter Dichtungsring 130 vorgesehen, der an Bereichen des Stützrings 116, des äußeren Polschuh 112 und einem unteren Bereich einer Isolierung 118' anliegt und eine Dichtung des durch die Polschuhe 111, 112 eingeschlossenen Raumes von dem Vakuumraum im Bereich eines zu untersuchenden Objekts und innerhalb des Elektronenmikroskopiesystems bereitstellt.

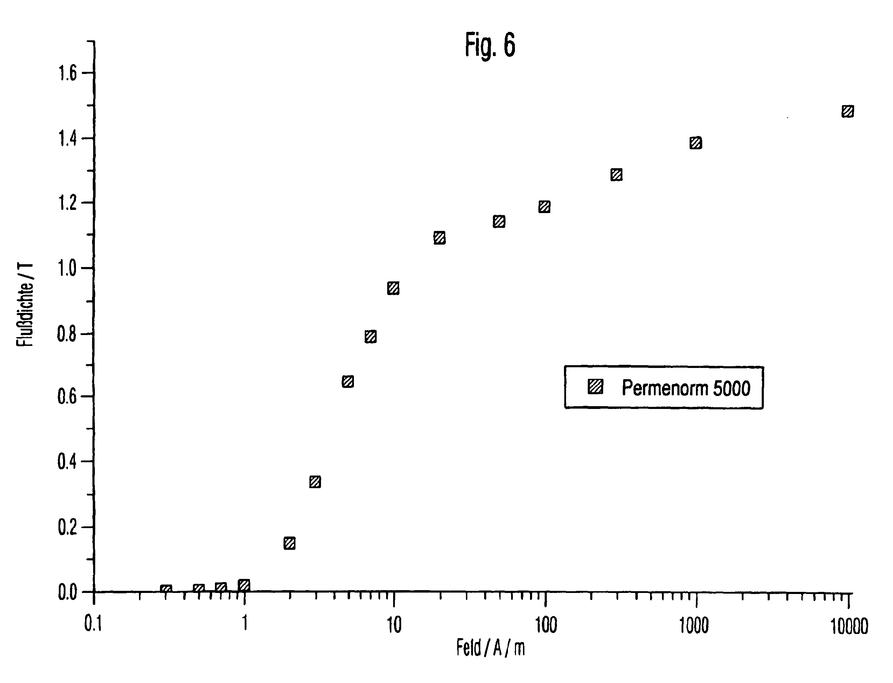

Die Polschuhanordnung ist aus Permenorm® 5000 H3, einer Eisen-Nickel-Legierung, durch Drehen und anschließendes Ausglühen gefertigt. Ein Diagramm der vom Feld abhängigen Flußdichte bzw. Magnetisierung dieses Materials ist in Figur 6 wiedergegeben.

In dem zwischen dem inneren Polschuh 111 und dem äußeren Polschuh 112 gebildeten Innenraum ist ein Spulenkörper 115 angeordnet. Der Spulenkörper 115 umfaßt koaxial zur optischen Achse angeordnete Drahtspulen mit einer Drahtdicke von 0,8 mm und ist aus Kupfer gefertigt. Die Zahl der Windungen beträgt 650. Die Spulen können bei einer Stromstärke von maximal 2A betrieben werden. Eine bei Stromdurchfluß durch die Spulen entstehende Wärmeleistung liegt im Bereich von etwa 20 Watt. Zwischen die Spulenwindungen ist ein Epoxy-Harz eingefüllt, das nach Aushärten thermische und mechanische Stabilität hervorruft.

Der Spulenkörper 115 ist in seiner Form im Wesentlichen der Form des durch die Polschuhe 111, 112 gebildeten Innenraums angepaßt, ohne diesen völlig auszufüllen. So erstrecken sich eine obere Seite und eine innere und eine äußere Seite des Spulenkörpers 115 im Wesentlichen parallel zu den jeweiligen, gegenüberliegenden Flächen der Polschuhanordnung. Zur äußeren Seite 191 des inneren Polschuhs 111, im Wesentlichen zur oberen Seite hin und zu einer unteren Seite hin wird der Spulenkörper 115 durch eine erste Ummantelung 120 spaltfrei eingeschlossen und in einem sich parallel zur z-Achse erstreckenden Bereich der äußeren Seite des Spulenkörpers 115 durch eine zweite Ummantelung 122 spaltfrei umschlossen. Die Ummantelungen 120, 122 sind aus Kupfer gefertigt und dienen der Aufnahme und Ableitung von Wärme, die bei Stromdurchlauf in den Drahtspulen des Spulenkörpers 115 erzeugt wird.

Zwischen der ersten Ummantelung 120 und der äußeren Seite 191 des inneren Polschuhs 111 ist ein sich über die Gesamtheit des der ersten Ummantelung 120 gegenüberliegenden Bereich des inneren Polschuhs 111 ein Spalt 123 belassen, um eine thermische Isolierung bereitzustellen und eine Erwärmung des Polschuhmaterials im Wesentlichen zu verhindern. In einem in z-Richtung obersten Bereich des inneren Polschuhs 111 ist ein ringförmiger Abstandhalter 131 zwischen einem kurzen, vertikalen Fortsatz 120' der ersten Ummantelung 120 und der äußeren Seite 191 des inneren Polschuhs 111 eingesetzt, um eine Berührung von Polschuh 111 und erster Ummantelung 120 zu verhindern und den Spalt 123 bereitzustellen. An den vertikalen Fortsatz der ersten Ummantelung 120 schließt sich in horizontaler Richtung nach radial außen ein von Kühlwasser durchflossenes Rohr 121 an. Zwischen äußerem Polschuh 112 und Spulenkörper 115 ist zur thermischen Isolierung ein Spalt 124 belassen.

Die zweite Ummantelung 122 weist im Wesentlichen eine invertierte L-Form auf und verläuft parallel zu einem zur Achse 101 parallelen Abschnitt der äußeren Seite des Spulenkörpers 115, während sie sich in horizontaler Richtung räumlich an die erste Ummantelung 120 anschließt und eine Bohrung zur Aufnahme einer Schraube 153 aufweist, die zum Verbinden von innerem Polschuh 111 und Spulenkörper 115 mit Ummantelungen 120, 122 unter Verwendung eines Vermittlungskörpers 135 vorgesehen ist. Zwischen einem Kopf der Schraube 153 und der zweiten Ummantelung 122 ist eine Unterlagscheibe 132 angeordnet. Der Flanschbereich 111'' des inneren Polschuhs 111 sowie ein diesem gegenüberliegender Flanschbereich 112' des äußeren Polschuhs 112 weisen miteinander fluchtende Bohrungen 154 und 155 zum Verschrauben der beiden Polschuhe 111, 112 miteinander auf. Der äußere Polschuh 112 weist darüber hinaus an seiner äußeren Seite 181 im Bereich des Übergangs von Konusform zum Flanschbereich 112' eine Stufenform auf, die der Einpassung der Polschuhanordnung in ein entsprechendes, zur Aufnahme gefertigtes Teil der Elektronenmikroskopieanordnung dient.

Eine Isolierung 118 aus Kunststoff erstreckt sich parallel zu und entlang der inneren Seite 190 des inneren Polschuhs 111 in einem unteren Bereich über ein unterstes Ende 192 des inneren Polschuhs 111 hinaus bis etwa zu einer untersten Stelle 182 des äußeren Polschuhs 112. In einem oberen Bereich geht die Isolierung 118 parallel zum inneren Polschuh 111 in einen Flanschbereich 118'' über, der etwa bis zur Mitte des Flanschbereichs 111'' des inneren Polschuhs 111 reicht. In einem Randbereich des Flanschteils 118'' der Isolierung 118 ist eine Bohrung zur Aufnahme einer die Isolierung 118 mit dem inneren Polschuh 111 verbindenden Schraube 152 vorgesehen. Ebenfalls in einem Flanschbereich 118'' der Isolierung 118 ist in einer dem inneren Polschuh 111 zugewandten Seite der Isolierung 118 eine ringförmige Aussparung zur Aufnahme eines Dichtungsrings 133 vorgesehen. In einem konusförmigen Bereich der inneren Seite des inneren Polschuhs 111 ist die Isolierung 118 vom inneren Polschuh 111 unter Belassung eines Spalts beabstandet. Ebenso wie der innere Polschuh 111 nimmt die Isolierung 118 in einem unteren Bereich eine Hohlzylinderform 118' an. In diesem hohlzylinderförmigen Bereich 118' der Isolierung 118 weist diese eine ringförmige, sich fast über die gesamte Höhe des hohlzylinderförmigen Bereichs erstreckende Aussparung 117 auf, die nicht dargestellte sattelförmige Ablenkspulen zum Ablenken des Elektronenstrahls aufnimmt.

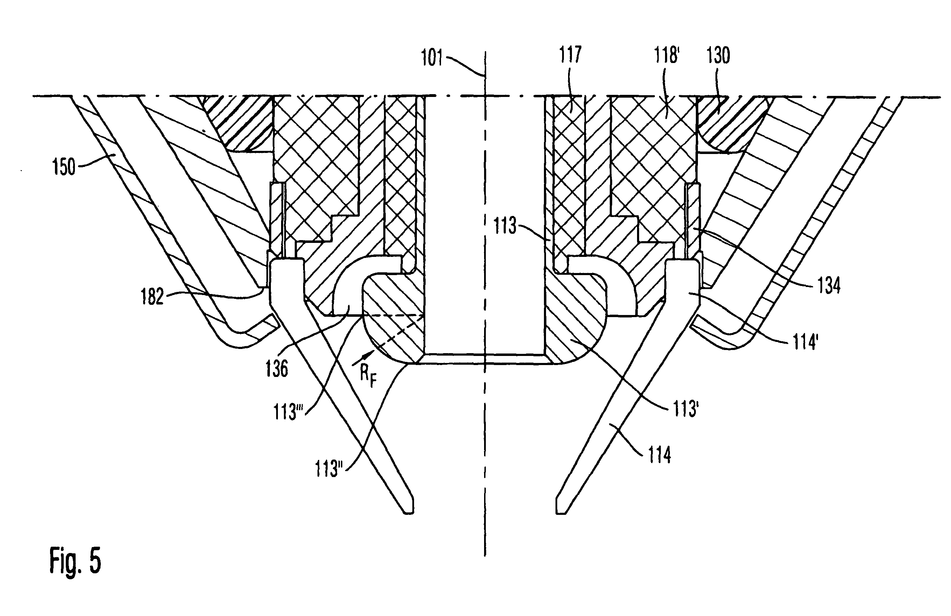

In den Innenradius des hohlzylinderförmigen Bereichs 118' der Isolierung 118 ist das eine erste Elektrode der elektrostatischen Linse ausbildende Strahlrohr 113 eingepasst. Das Strahlrohr 113 erstreckt sich in z-Richtung sowohl über ein oberes wie auch eine unteres Ende des Hohlzylinderbereichs 118' der Isolierung 118 hinaus. Der Innendurchmesser des Strahlrohrs 113 beträgt etwa 4,5 mm. Ein unteres bzw. unterstes Ende des Strahlrohrs 113 weist einen Abstand zur untersten Stelle bzw. dem unteren Ende 182 des äußeren Polschuhs 112 von etwa 5 mm auf. Wie insbesondere aus Figur 5 ersichtlich, weist das Strahlrohr 113 in dieser Ausführungsform einen Endflansch 113' auf, der im axialen Querschnitt eine verrundete Form aufweist und an seiner größten sich radial nach außen erstreckenden Ausdehnung einen Durchmesser von etwa 8,5 mm aufweist. Der Endflansch 113' geht von einem in Richtung der Objektebene weisenden Frontabschnitt 113'' in verrundeter Form in einen im Wesentlichen parallel zur Achse 101 angeordneten Mantelabschnitt 113''' über, wobei der Krümmungsradius $R_p$ dieser Verrundung etwa 2 mm beträgt. Der diesem Endflansch 113' zuweisende unterste Teil der Isolierung 118 und die Form des Endflansches 113' des Strahlrohrs 113 sind derart aneinander angepasst, daß ihre Flächen im Wesentlichen parallel angeordnet sind und so ein Spalt 136 von halbrunder Form mit gleichmäßigem Abstand um den Endflansch 113' herum entsteht. Der Endflansch 113' dient dazu, den Kunststoff der Isolierung 118 vor Elektronen und durch diese verursachte Aufladung zu schützen. Im untersten Bereich der Isolierung ist eine Aussparung zur Aufnahme eines Rings 134 vorgesehen, der auf einer von der Isolierung abgewandten Seite zur Anlage an einen Bereich des äußeren Polschuhs kommt.

Des weiteren weist die elektrostatische Linse der Objektivlinse 100 eine Abschlußelektrode 114 als eine zweite Elektrode auf. Diese Abschlußelektrode 114 ist im Wesentlichen von konischer Form, wobei ein Winkel zwischen einer äußeren Seite der Abschlußelektrode 114 und der Achse 101 gleich dem Winkel α zwischen der äußeren Seite 181 des äußeren Polschuhs 112 und der Achse 101 ist, wobei äußerer Polschuh 112 und Abschlußelektrode 114 miteinander fluchten. Die Abschlußelektrode 114 verjüngt sich in z-Richtung bis hin zu einer zentralen Öffnung von etwa 5 mm Innendurchmesser. An einem oberen Ende der Abschlußelektrode 114 geht diese in einen ring- bzw. hohlzylinderförmigen Bereich 114' über, wobei eine Außenfläche dieses Ringbereichs 114' einer axialen Innenfläche des äußeren Polschuhs 112 flächig gegenüberliegt und der zwischen diesen ausgebildete, etwa 150 μm breite Spalt schmal genug ist, um eine magnetische Kopplung von Abschlußelektrode 114 und äußerem Polschuh 112 zu ermöglichen, wodurch eine noch bessere Abschirmung des Magnetfeldes in der Objektivlinse 100 von einem Bereich außerhalb der Objektivlinse 100 erreicht wird.

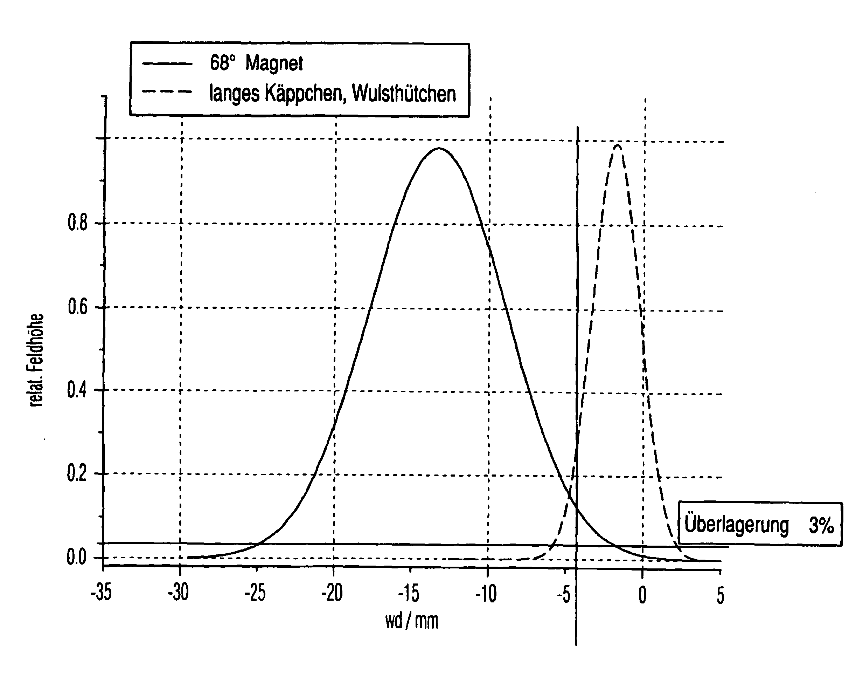

Das untere Ende des Strahlrohrs 113 weist in z-Richtung einen Abstand $A_2$ von etwa 5 mm zu einer untersten Stelle bzw. dem unteren Ende der Abschlußelektrode 114 auf. Während am Strahlrohr 113 eine positive Spannung von 8kV anliegt, ist die Abschlußelektrode 114 vorzugsweise auf Erdpotential geschaltet. Durch die Wahl dieser gegenüber dem Stand der Technik größeren Abstände der Elektroden 113, 114 der elektrostatischen Linse voneinander und von der Polschuhanordnung wird das elektrostatische Verzögerungs- und Fokussierungsfeld von dem durch die Polschuhanordnung erzeugten Magnetfeld weitgehend separiert, die Felder der beiden Linsen überlappen in einem Bereich von weniger als 5% ihrer Feldintegrale, wie aus dem Diagramm in Figur 7 ersichtlich. (Die Abschlusselektrode mit Endflansch ist in der Legende von Figur 7 als "langes Käppchen, Wulsthütchen" bezeichnet.)

Die Abschlußelektrode 114 ist aus Mumetall®, nämlich einem von der Vakuumschmelze Hanau, Deutschland, unter dem Namen Hyperm 766 erhältlichen Material gefertigt.

Die Abschlußelektrode 114 wird durch zwei gegenüberliegende, in einem oberen Bereich mit Schrauben 151 am äußeren Polschuh 112 befestigte Klammern 150 gehalten. Die Klammern 150 sind in ihrem unteren Bereich an einem obersten konusförmigen Abschnitt der Abschlußelektrode 114 angeordnet. Die Abschlußelektrode 114 wird durch die Isolierung 118' gehalten und zentriert. Zur elektrischen Isolation der Klammern 150 vom äußeren Polschuh 112 wird keramisches Isolierungsmaterial unter der äußeren Polschuh 112 und Klammer 150 verbindenden Schraube 151 verwendet. Diese Anordnung bzw. Halterung ermöglicht ein leichtes Auswechseln der Abschlußelektrode 114. Zudem kann die Abschlußelektrode 114 elektrisch isoliert von dem äußeren Polschuh 112 auf ein anderes Potential als Erdpotential geschaltet werden.

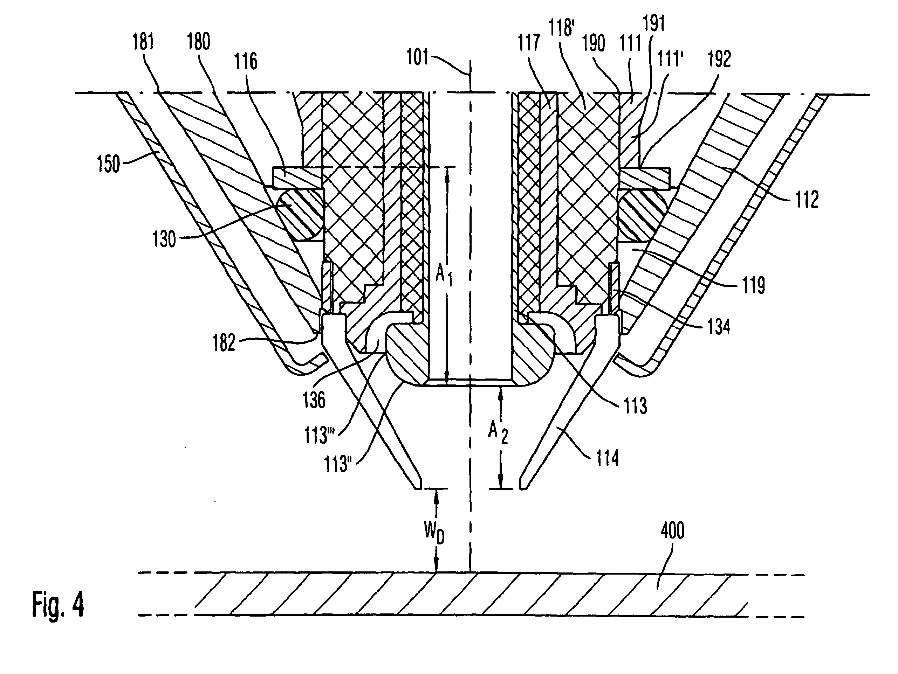

In Figur 4 ist zusätzlich ein zu untersuchendes Objekt 400 sowie ein Arbeitsabstand $W_D$ zwischen dem unteren Ende der Abschlußelektrode 114 und einer Oberfläche des Objekts 400 sowie die Abstände $A_1$ und $A_2$ dargestellt.

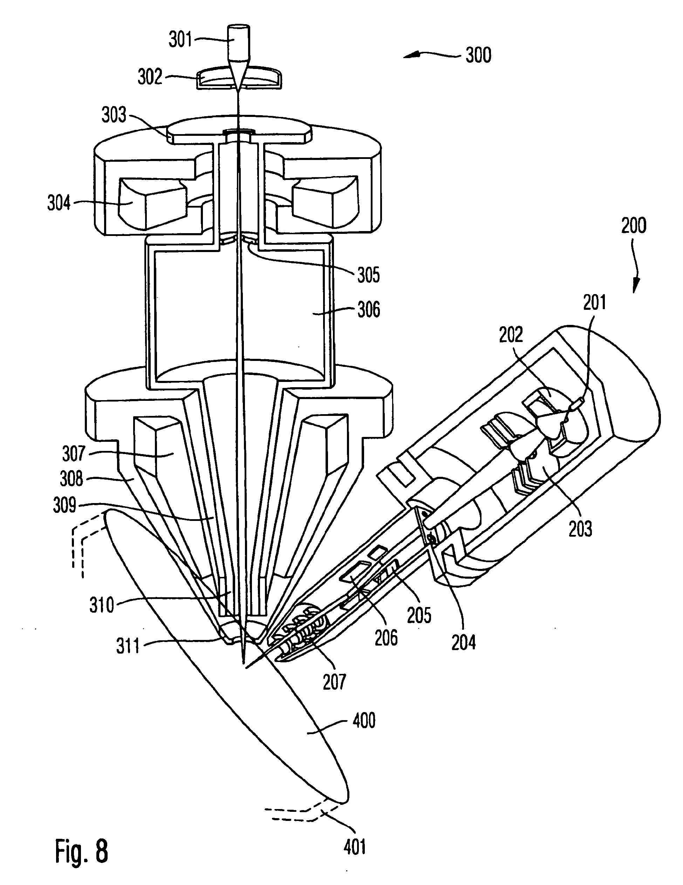

In Figur 8 ist in schematischer, vereinfachter Form ein Ausführungsbeispiel des Untersuchungssystem zum Abbilden und Manipulieren eines Objekts 400 dargestellt. Das Untersuchungssystem umfasst Elektronenmikroskopiesystem 300 zum Abbilden eines Bereichs des Objekts 400 sowie Ionenstrahlbearbeitungssystem 200 zum Manipulieren des Objekts 400.

Wie aus Figur 8 ersichtlich, schneiden sich die optischen Achsen von Elektronenmikroskopiesystem 300 und Ionenstrahlbearbeitungssystem 200 im Wesentlichen in einer durch die plane Oberfläche des Objekts 400 definierten Ebene, wobei die optische Achse des Ionenstrahlbearbeitungssystems 200 in etwa orthogonal zu dieser Ebene angeordnet ist und der Ionenstrahl entsprechend senkrecht auf eine Oberfläche des Objekts 400 auftrifft. Der Einfallswinkel des Elektronenstrahls auf das Objekt 400 beträgt in der Figur dargestellten Anordnung in etwa 35°, während der Arbeitsabstand, d.h. der Abstand zwischen der Oberfläche des Objekts 400 und der untersten, radial innersten Stelle in der zentralen Öffnung der Abschlußelektrode etwa 4 mm beträgt.

Im Elektronenmikroskopiesystem 300 wird ein Primärelektronenstrahl durch eine Elektronenstrahlquelle erzeugt, welche eine Kathode 301, vorzugsweise einen Schottky-Feldemitter, und eine der Kathode 301, gegenüberliegende Anode 303 umfaßt. Die emittierten Elektronen durchlaufen zudem einen zwischen Kathode 301 und Anode 303 angeordneten Extraktor 302. Der beschleunigte Primärelektronenstrahl tritt durch eine Bohrung am Boden der Anode 303 hindurch und wird anschließend von einer Kollimatoranordnung 304 kollimiert. Der Elektronenstrahl durchläuft nach einer Aperturblende 305 einen Innenraum 306 des Elektronenmikroskopiesystems 300, in dem ein nicht dargestellter Detektor zum Nachweis von Sekundärelektronen oder Rückstreuelektronen angeordnet ist. Mittels der aus der Polschuhanordnung mit innerem Polschuh 309 und äußerem Polschuh 308 sowie dem zwischen diesen angeordneten Spulenkörper 307 ausgebildeten Magnetlinse und der elektrostatischen Linse 310, 311, welche zusammen die Objek-tivlinse ausbilden, wird der Elektronenstrahl fokussiert. In der Objektivlinse sind zudem symmetrisch um den Strahlengang herum Sattelspulen zum Ablenken des Elektronenstrahls angeordnet. Aus der Objektivlinse tritt der Elektronenstrahl aus und trifft unter einem Winkel von etwa 35° bei einem Arbeitsabstand von etwa 4 mm auf die Objektoberfläche. Die Objektivlinse wurde im vorangehenden Ausführungsbeispiel bereits detailliert beschrieben.

Ionenstrahlbearbeitungssystem 200 weist eine Ionenquelle 201 auf, die eine Anordnung mit einem an einer Spitze angeordneten Tropfen flüssigen Galliums umfasst, aus welchem mit Hilfe einer Extraktionselektrode 202 ein Ionenstrahl extrahiert wird. Dieser durchläuft, vereinfacht dargestellt, beim Durchgang durch die Ionenoptik der FIB-Säule 200 nacheinander einen Kollimator 203, eine variable Blende 204, einen Satz von Elektroden 205 und 206 zur Ablenkung und Ausrichtung des Ionenstrahls und schließlich eine Anordnung von strahlformenden Einzellinsen 207, bevor der Ionenstrahl aus der FIB-Säule austritt.

Der fokussierte Ionenstrahl trifft in Figur 8 etwa rechtwinklig zur Objektoberfläche auf das Objekt, so daß Gräben oder Löcher mit senkrechten Wänden in der Objektoberfläche bei simultaner Beobachtung durch die Elektronenmikroskopieanordnung erzeugt werden können.

Weiterhin ist in Figur 8 eine Objekthalterung 401 zum Haltern und Ausrichten des Objekts 400 vor Elektronenmikroskopiesystem 300 und Ionenstrahlbearbeitungssystem 200 angedeutet.

Ein großer Vorteil des erfindungsgemäßen Systems ist es, ein Objekt gleichzeitig beobachten und bearbeiten zu können. Abbilden der Objektbearbeitung in situ ist insbesondere zur Endpunktbestimmung bei der Erzeugung besonders komplexer und/oder kleiner Strukturen von Bedeutung. Simultanes Bearbeiten und Abbilden wird unter anderem dadurch ermöglicht, daß das magnetische Feld der Magnetlinse der Objektivlinse des Elektronenstrahlmikroskopiesystems derart durch die Objektivlinse abgeschirmt wird, daß im Bereich der Objektoberfläche bzw. des vom Ionenstrahl durchsetzten Raums ein Magnetfeld so gering ist, daß kein oder ein vernachlässigbar kleiner störender Einfluß auf den Ionenstrahl ausgeübt wird. Dies ist insbesondere gegenüber sogenannten "single pole"-Objektivlinsen von großem Vorteil, deren Raumbedarf zwar recht klein gestaltet werden kann, die jedoch naturgemäß ein großes Magnetfeld im Bereich des Objekts erzeugen und so nicht gleichzeitig mit einem fokussierten Ionenstrahl eingesetzt werden können.

Ausgehend von einem Winkel von 34° oder weniger zwischen der Außenseite des äußeren Polschuhs der Objektivlinse der Elektronenmikroskopieanordnung und einem Winkel von 20° zwischen einer zumindest in einem dem Objekt zuweisenden unteren Bereich konusförmig gestalteten Außenseite der FIB-Säule und deren optischer Achse (halber Öffnungswinkel) lassen sich FIB-Säule und Elektronenmikroskopieanordnung in einer Ebene senkrecht zur Objektebene derart anordnen, daß in dieser 180° überspannenden Ebene der fokussierte Ionenstrahl unter einem Winkel von etwa 21° bis (180° - 2x34° - 20° =) 92° auf das Objekt treffen kann, wobei der Elektronenstrahl gleichzeitig unter einem Winkel von etwa (0° + 2x20° + 34° =) 74° bis (180° - 34° =) 146° auf das Objekt treffen kann, wobei der Winkel zwischen Elektronenstrahl und Ionenstrahl immer mindestens (20° + 34° =) 54° beträgt. Damit läßt sich der fokussierte Ionenstrahl auch beispielsweise um 2° in jede Richtung abweichend von der Orthogonalen auf die Objektebene richten, was zum Beispiel für das Erzeugen von Proben für die Transmissionselektronenmikroskopie von Bedeutung ist.

**Patentansprüche**

**1.** Objektivlinse (100) für ein Elektronenmikroskopiesystem mit magnetischer und elektrostatischer Fokussierung zur Erzeugung einer Abbildung eines in einer Objektebene anordenbaren Objekts, umfassend:

eine bezüglich einer sich in einer z-Richtung erstreckenden optischen Achse (101) der Objektivlinse (100) im wesentlichen rotationssymmetrische Polschuhanordnung zur Erzeugung eines fokussierenden Magnetfeldes mit einem inneren Polschuh (111) und einem äußeren Polschuh (112), wobei ein Polschuhspalt (119) zwischen dem inneren und dem äußeren Polschuh (111, 112) gebildet ist an einer in z-Richtung untersten Stelle des inneren Polschuhs (192), wo dieser von dem äußeren Polschuh (112) einen in z-Richtung orientierten Spaltabstand aufweist;

einen in einem Raum zwischen dem inneren und dem äußeren Polschuh (111, 112) angeordneten Spulenkörper (115);

eine bezüglich der optischen Achse (101) im wesentlichen rotationssymmetrische Elektrodenanordnung zur Erzeugung eines fokussierenden elektrostatischen Feldes mit einem den inneren Polschuh (111) entlang der optischen Achse (101) durchsetzenden Strahlrohr (113) mit einem unteren Ende und einer mit Abstand von dem unteren Ende des Strahlrohrs (113) angeordneten Abschlußelektrode (114),

wobei einem Bereich innerhalb von wenigstens 3 cm um den Polschuhspalt (119) gilt:

wenigstens bereichsweise verjüngt sich der innere Polschuh (111) nach unten und weist dort einen inneren Konuswinkel β und einen äußeren Konuswinkel χ zur z-Richtung auf, der äußere Polschuh (112) erstreckt sich wenigstens bereichsweise konisch nach unten und weist dort einen inneren Konuswinkel Δ und einen äußeren Konuswinkel α zur z-Richtung auf,

**dadurch gekennzeichnet, dass** die Objektivlinse dazu ausgebildet ist, dass ein Arbeitsabstand zwischen der Abschlußelektrode (114) und der Objektebene kleiner als 2 mm für Elektronen ist, die das Strahlrohr (113) mit etwa 30 keV durchlaufen, und wobei gilt:

$$30° < \alpha < 35° \text{ und } 10° < \Delta\text{-}\chi < 14°.$$

**2.** Objektivlinse (100) nach Anspruch 1, wobei der äußere Polschuh (112) außen im wesentlichen durch eine Konusfläche mit einem Konuswinkel $\alpha$ zur z-Richtung begrenzt ist, wobei die Abschlußelektrode (114) außen im wesentlichen durch eine Konusfläche mit einem Konuswinkel $\alpha'$ zur z-Richtung begrenzt ist, wobei die Abschlußelektrode (114) zum Reduzieren des Magnetfelds in der Objektebene im wesentlichen spaltfrei magnetisch an den äußeren Polschuh (112) gekoppelt ist.

**3.** Objektivlinse (100) nach Anspruch 2, wobei ein Spalt zwischen der Abschlußelektrode (114) und dem äußeren Polschuh (112) kleiner als 0,6 mm, vorzugsweise kleiner als 0,2 mm ist.

**4.** Objektivlinse (100) nach einem der Ansprüche 2 bis 3, wobei ein Bereich der Abschlußelektrode (114) einem Bereich des äußeren Polschuhs (112) flächig gegenüberliegt.

**5.** Objektivlinse (100) nach einem der Ansprüche 1 bis 4, wobei ein Abstand ($A_1$) zwischen der in z-Richtung untersten Stelle (192) des inneren Polschuhs (111) und dem unteren Ende des Strahlrohrs (113) größer ist als 9 mm, insbesondere größer als 10 mm ist.

**6.** Objektivlinse (100) nach einem der vorangehenden Ansprüche, wobei das elektrostatische Feld und das Magnetfeld bezogen auf die Feldintegrale um weniger als 5 % überlappen.

**7.** Objektivlinse (100) nach einem der vorangehenden Ansprüche, wobei das Strahlrohr (113) eine durch einen in z-Richtung untersten Bereich (182) des äußeren Polschuhs (112) gebildete Öffnung des äußeren Polschuhs (112) durchsetzt und das untere Ende des Strahlrohrs (113) in z-Richtung von der Öffnung des äußeren Polschuhs (112) mit Abstand angeordnet ist.

**8.** Objektivlinse (100) nach Anspruch 7, wobei das untere Ende des Strahlrohrs (113) einen sich radial über einen Außendurchmesser des Strahlrohrs hinaus erstreckenden Endflansch (113') aufweist.

**9.** Objektivlinse (100) nach Anspruch 8, wobei der Endflansch (113') im Axialquerschnitt einen verrundeten Übergang von einem Frontabschnitt (113'') in einen Mantelabschnitt (113''') aufweist, wobei ein Krümmungsradius der Verrundung größer als 1 mm ist.

**10.** Objektivlinse (100) nach einem der Ansprüche 7 bis 9, wobei ein Abstand ($A_2$) zwischen dem unteren Ende des Strahlrohrs (113) und dem unteren Ende der Abschlußelektrode (114) größer als 3 mm ist.

**11.** Objektivlinse (100) nach einem der vorangehenden Ansprüche, wobei die Abschlußelektrode (114) im wesentlichen bis zu einer zentralen Öffnung in der Abschlußelektrode (114) hin sich konisch verjüngt.

**12.** Objektivlinse (100) nach Anspruch 11, wobei ein Innendurchmesser der Öffnung der Abschlußelektrode (114) im wesentlichen einem Innendurchmesser des Strahlrohrs (113) entspricht.

**13.** Objektivlinse (100) nach einem der vorangehenden Ansprüche, wobei der äußere Polschuh sich nach unten verjüngt.

**14.** Objektivlinse (100) nach einem der vorangehenden Ansprüche, wobei der Spaltabstand größer als 3 mm ist.

**15.** Objektivlinse (100) nach einem der vorangehenden Ansprüche, wobei der innere Polschuh (111) sich von seinem unteren Ende (192) aus als ein Zylindermantel (111') 1 mm bis 2 mm nach oben erstreckt und dann sich konisch erweitert.

**16.** Objektivlinse (100) nach einem der vorangehenden Ansprüche, wobei der innere Polschuh (111) an seinem unteren Ende (192) einen Innendurchmesser von 6 mm bis 8 mm aufweist.

**17.** Untersuchungssystem zur Beobachtung und zur Manipulation eines zu untersuchenden Objekts (400), umfassend:

ein Elektronenmikroskopiesystem (300) mit einer Objektivlinse nach einem der Ansprüche 1 bis 16, und ein Ionenstrahlbearbeitungssystem (200) zum Manipulieren des Objekts (400) mittels eines emittierten Ionenstrahls,

eine Objekthalterung (401) zur Halterung und Ausrichtung des Objekts (400) vor dem Ionenstrahlbearbeitungssystem (200) und dem Elektronenmikroskopiesystem (300), mit der ein flächig ausgedehntes Objekt (400) derart vor dem Elektronenmikroskopiesystem (300) und dem Ionenstrahlbearbeitungssystem (200) ausrichtbar ist, daß der Ionenstrahl die Objektoberfläche orthogonal schneidet.

18. Untersuchungssystem nach Anspruch 17, wobei das Objekt (400) derart vor dem Elektronenmikroskopiesystem (300) und dem Ionenstrahlbearbeitungssystem (200) ausrichtbar ist, daß der Ionenstrahl die Objektoberfläche um einen Winkel von bis zu 2° von der Orthogonalen auf die Objektoberfläche abweichend schneidet.

## Claims

1. An objective lens (100) for an electron microscopy system for performing magnetic and electrostatic focusing for generating an image of an object which is positionable in an object plane, comprising:

a pole shoe arrangement for generating a focusing magnetic field, which pole shoe arrangement is substantially rotationally symmetric about an optical axis (101) of the objective lens (100), wherein the optical axis extends in a z-direction and wherein the objective lens (100) comprises an inner pole shoe (111) and an outer pole shoe (112), wherein a pole shoe gap (119) is formed between the inner and outer pole shoes (111, 112) at a lowermost portion of the inner pole shoe (192) with respect to the z-direction, wherein the lowermost portion and the outer pole shoe (112) form a gap spacing oriented in the z-direction;

a coil body (115) disposed in a space between the inner and the outer pole shoes (111, 112); and

an electrode arrangement for generating a focusing electrostatic field, which electrode arrangement is substantially rotationally symmetric about the optical axis (101) and comprises a beam tube (113) which extends along the optical axis (101) through the inner pole shoe (111) and has a lower end, and a terminal electrode (114) disposed spaced apart from the lower end of the beam tube (113),

wherein within a region of at least 3 cm around the pole shoe gap (119), the following applies:

the inner pole shoe (111) tapers downwards at least sectionally and has there an inner cone angle $\beta$ and an outer cone angle $\chi$ with respect to the z-direction, the outer pole shoe (112) extends conically downwards at least sectionally and has there an inner cone angle $\Delta$ and an outer cone angle $\alpha$ with respect to the z-direction,

**characterized in that** the objective lens is configured such that a working distance between the terminal electrode (114) and the object plane is smaller than 2 mm for electrons which pass through the beam tube (113) at about 30 keV, and

wherein the following applies:

$$30° < \alpha < 35° \text{ and } 10° < \Delta-\chi < 14°.$$

2. The objective lens (100) according to claim 1, wherein the outer pole shoe (112) is delimited on the outside substantially by a cone surface having a cone angle $\alpha$ with respect to the z-direction, wherein the terminal electrode (114) is delimited on the outside substantially by a cone surface having a cone angle $\alpha'$ with respect to the z-direction, wherein the terminal electrode (114) is magnetically coupled to the outer pole shoe (112) by a substantially gap-free coupling between the terminal electrode and the outer pole shoe for reducing the magnetic field in the object plane.

3. The objective lens (100) according to claim 2, wherein a gap between the terminal electrode (114) and the outer pole shoe (112) is smaller than 0.6 mm, preferably, smaller than 0.2 mm.

4. The objective lens (100) according to one of claims 2 to 3, wherein a region of the terminal electrode (114) and a region of the outer pole shoe (112) are arranged to be opposed to each other.

5. The objective lens (100) according to one of claims 1 to 4, wherein a distance ($A_1$) between the lowermost portion (192) with respect to the z-direction of the inner pole shoe (111) and the lower end of the beam tube (113) is larger than 9 mm, in particular, larger than 10 mm.

6. The objective lens (100) according to one of the preceding claims, wherein the electrostatic field and the magnetic field overlap by less than 5 % with respect to the field integral.

7. The objective lens (100) according to one of the preceding claims, wherein the beam tube (113) extends through an opening of the outer pole shoe (112) formed by a lowermost portion (182) with respect to the z-direction of the outer pole shoe (112), and the lower end of the beam tube (113) is disposed spaced apart in z-direction from the opening of the outer pole shoe (112).

8. The objective lens (100) according to claim 7, wherein the lower end of the beam tube (113) comprises an end flange (113') extending radially beyond an outer diameter of the beam tube.

9. The objective lens (100) according to claim 8, wherein the end flange (113') comprises a connecting portion between a front face (113'') and a sheath section (113'''), wherein the connecting portion is rounded in an axial cross-section, a radius of curvature of the rounding being greater than 1 mm.

10. The objective lens (100) according to one of claims 7 to 9, wherein a distance ($A_2$) between the lower end of the beam tube (113) and the lower end of the terminal electrode (114) is larger than 3 mm.

11. The objective lens (100) according to one of the preceding claims, wherein the terminal electrode (114) tapers conically substantially up to a central opening in the terminal electrode (114).

12. The objective lens (100) according to claim 11, wherein an inner diameter of the opening of the terminal electrode (114) corresponds substantially to an inner diameter of the beam tube (113).

13. The objective lens (100) according to one of the preceding claims, wherein the outer pole shoe tapers downwards.

14. The objective lens (100) according to one of the preceding claims, wherein the gap spacing is larger than 3 mm.

15. The objective lens (100) according to one of the preceding claims, wherein the inner pole shoe (111) extends upwards from its lower end (192) by 1 mm to 2 mm in the form of a cylinder sheath (111') and then widens conically.

16. The objective lens (100) according to one of the preceding claims, wherein the inner pole shoe (111) has an inner diameter of from 6 mm to 8 mm at its lower end (192).

17. An examination system for observing and manipulating an object (400) to be examined, comprising:

   an electron microscopy system (300) with an objective lens according to one of claims 1 to 16, and
   an ion beam processing system (200) for manipulating the object (400) by means of an emitted ion beam,
   an object holder (401) for holding and orienting the object (400) in front of the ion beam processing system (200) and the electron microscopy system (300) by means of which a two-dimensionally extended object (400) is orientable in front of the electron microscopy system (300) and the ion beam processing system (200) such that the ion beam intersects the object surface orthogonally.

18. The examination system according to claim 17, wherein the object (400) is orientable in front of the electron microscopy system (300) and the ion beam processing system (200) such that the ion beam intersects the object surface at an angle deviating from the orthogonal up to about 2°.

**Revendications**

1. Lentille d'objectif (100) pour un système de microscopie électronique avec focalisation magnétique et électrostatique permettant de générer une reproduction d'un objet pouvant être disposé dans un plan d'objet, comprenant :

   un agencement d'épanouissement polaire, sensiblement à symétrie de révolution autour d'un axe optique (101) de la lentille d'objectif (100) s'étendant dans une direction z, pour la production d'un champ magnétique de focalisation, ayant un épanouissement polaire interne (111) et un épanouissement polaire externe (112), un entrefer d'épanouissement polaire (119) étant formé entre les épanouissements polaires interne et externe (111, 112) à un endroit (192) le plus bas dans la direction z de l'épanouissement polaire interne, où ce dernier présente un écart d'entrefer orienté dans la direction z de l'épanouissement polaire externe (112) ;
un corps de bobine (115) disposé dans un espace entre les épanouissements polaires interne et externe (111, 112) ;
un agencement d'électrodes qui présente sensiblement une symétrie de révolution autour de l'axe optique (101) pour la production d'un champ électrostatique de focalisation avec un tube de faisceau (113) doté d'une extrémité basse et introduit dans l'épanouissement polaire interne (111) le long de l'axe optique (101), et qui comporte une électrode de terminaison (114) disposée à distance de l'extrémité basse du tube de faisceau (113), dans laquelle, dans une zone d'au moins 3cm autour de l'entrefer d'épanouissement polaire (119) :

l'épanouissement polaire interne (111) s'amincit au moins par zones vers le bas et y présente un angle de conicité interne $\beta$ et un angle de conicité externe $\chi$ par rapport à la direction z, l'épanouissement polaire externe (112) s'étend au moins par zones de manière conique vers le bas et y présente un angle de conicité interne $\Delta$ et un angle de conicité externe $\alpha$ par rapport à la direction z,

**caractérisée en ce que**
la lentille d'objectif est formée de sorte qu'une distance de travail entre l'électrode de terminaison (114) et le plan d'objet soit inférieure à 2 mm pour des électrons qui traversent le tube de faisceau (113) avec environ 30 keV, et dans laquelle :

$$30° < \alpha < 35° \text{ et } 10° < \Delta-\chi < 14°.$$

2. Lentille d'objectif (100) selon la revendication 1, l'épanouissement polaire externe (112) étant limité à l'extérieur sensiblement par une surface conique avec un angle de conicité $\alpha$ par rapport à la direction z, l'électrode de terminaison (114) étant limitée à l'extérieur sensiblement par une surface conique avec un angle de conicité $\alpha'$ par rapport à la direction z, l'électrode de terminaison (114) étant sensiblement couplée de manière magnétique et sans entrefer à l'épanouissement polaire externe (112) afin de réduire le champ magnétique dans le plan d'objet.

3. Lentille d'objectif (100) selon la revendication 2, un entrefer entre l'électrode de terminaison (114) et l'épanouissement polaire externe (112) étant inférieur à 0,6mm, de préférence inférieur à 0,2 mm.

4. Lentille d'objectif (100) selon l'une des revendications 2 à 3, une zone de l'électrode de terminaison (114) étant située à plat en regard d'une zone de l'épanouissement polaire externe (112).

5. Lentille d'objectif (100) selon l'une des revendications 1 à 4, une distance (A1) entre l'endroit le plus bas dans la direction z (192) de l'épanouissement polaire interne (111) et l'extrémité basse du tube de faisceau (113) est supérieure à 9 mm, en particulier supérieure à 10 mm.

6. Lentille d'objectif (100) selon l'une quelconque des revendications précédentes, le champ électrostatique et le champ magnétique se chevauchant de moins de 5 % par rapport à l'intégrale de champ.

7. Lentille d'objectif (100) selon l'une quelconque des revendications précédentes, le tube de faisceau (113) étant introduit dans une ouverture de l'épanouissement polaire externe formée par une zone la plus basse (182) dans la direction z de l'épanouissement polaire externe (112), et l'extrémité basse du tube de faisceau étant disposée dans la direction z à une certaine distance de l'ouverture de l'épanouissement polaire externe (112).

8. Lentille d'objectif (100) selon la revendication 7, l'extrémité basse du tube de faisceau (113) présentant un rebord d'extrémité (113') s'étendant radialement au-delà d'un diamètre externe du tube de faisceau.

9. Lentille d'objectif (100) selon la revendication 7, le rebord d'extrémité (113') présentant dans sa section axiale une transition arrondie allant d'une section frontale (113") à une section formant gaine (113'''), un rayon de courbure de l'arrondi étant supérieur à 1 mm.

**10.** Lentille d'objectif (100) selon l'une des revendications 7 à 9, dans laquelle une distance (A2) entre l'extrémité basse du tube de faisceau (113) et l'extrémité basse de l'électrode de terminaison (114) est supérieure à 3 mm.

**11.** Lentille d'objectif (100) selon l'une quelconque des revendications précédentes, dans laquelle l'électrode de terminaison (114) s'amincit de manière conique sensiblement jusqu'à une ouverture centrale dans l'électrode de terminaison (114).

**12.** Lentille d'objectif (100) selon la revendication 11, dans laquelle un diamètre interne de l'ouverture de l'électrode de terminaison (114) correspond sensiblement à un diamètre interne du tube de faisceau (113).

**13.** Lentille d'objectif (100) selon l'une quelconque des revendications précédentes, dans laquelle l'épanouissement polaire externe s'amincit vers le bas.

**14.** Lentille d'objectif (100) selon l'une quelconque des revendications précédentes, dans laquelle l'écart d'entrefer est supérieur à 3 mm.

**15.** Lentille d'objectif (100) selon l'une quelconque des revendications précédentes, dans laquelle l'épanouissement polaire interne (111) s'étend de 1 mm à 2 mm vers le haut depuis son extrémité basse (192) en forme d'enveloppe cylindrique (111'), puis s'élargit de manière conique.

**16.** Lentille d'objectif (100) selon l'une quelconque des revendications précédentes, dans laquelle l'épanouissement polaire interne (111) présente à son extrémité basse (192) un diamètre interne de 6 mm à 8 mm.

**17.** Système d'examen pour observer et manipuler un objet à examiner (400), comportant :

un système de microscopie électronique (300) doté d'une lentille d'objectif selon l'une des revendications 1 à 16, et
un système de traitement à faisceau d'ions (200) pour manipuler l'objet (400) au moyen d'un faisceau d'ions émis, un support d'objet (401) servant à tenir et orienter l'objet (400) devant le système de traitement à faisceau d'ions (200) et le système de microscopie électronique (300), avec lequel un objet mis à plat (400) peut être orienté devant le système de microscopie électronique (300) et le système de traitement à faisceau (200) d'ions de manière telle que le faisceau d'ions croise la surface de l'objet à l'orthogonale.

**18.** Système d'examen selon la revendication 17, l'objet (400) pouvant être orienté devant le système de microscopie électronique (300) et le système de traitement à faisceau d'ions (200) de manière telle que le faisceau d'ions coupe la surface de l'objet d'un angle s'écartant jusqu'à 2° de la direction orthogonale à la surface de l'objet.

**Fig. 1**
(Stand der Technik)

Fig. 2

Fig. 3

EP 1 385 193 B1

Fig. 4

EP 1 385 193 B1

Fig. 5

Fig. 6

EP 1 385 193 B1

Fig. 8

## IN DER BESCHREIBUNG AUFGEFÜHRTE DOKUMENTE

**In der Beschreibung aufgeführte Patentdokumente**

- DE 19845329 A1
- EP 0910108 A1
- US 5731586 A